(19) Europäisches Patentamt
European Patent Office
Office européen des brevets

(11) **EP 1 118 196 B1**

(12) **EUROPÄISCHE PATENTSCHRIFT**

(45) Veröffentlichungstag und Bekanntmachung des Hinweises auf die Patenterteilung:
**27.08.2003 Patentblatt 2003/35**

(21) Anmeldenummer: **99953665.9**

(22) Anmeldetag: **01.09.1999**

(51) Int Cl.$^7$: **H04L 27/26**, H03K 9/00

(86) Internationale Anmeldenummer:
**PCT/DE99/02752**

(87) Internationale Veröffentlichungsnummer:
**WO 00/019675 (06.04.2000 Gazette 2000/14)**

(54) **DIGITALER EMPFÄNGER FÜR EIN MIT DISKRETER MULTITON-MODULATION ERZEUGTES SIGNAL**

DIGITAL RECEIVER FOR A SIGNAL GENERATED WITH DISCRETE MULTI-TONE MODULATION

RECEPTEUR NUMERIQUE POUR UN SIGNAL PRODUIT A L'AIDE DE LA MODULATION DISCRETE A TONALITES MULTIPLES

(84) Benannte Vertragsstaaten:
**FR GB IT**

(30) Priorität: **28.09.1998 DE 19844460**

(43) Veröffentlichungstag der Anmeldung:
**25.07.2001 Patentblatt 2001/30**

(73) Patentinhaber: **Infineon Technologies AG**
**81669 München (DE)**

(72) Erfinder: **SCHENK, Heinrich**
**D-81476 München (DE)**

(74) Vertreter: **Reinhard - Skuhra - Weise & Partner**
**Postfach 44 01 51**
**80750 München (DE)**

(56) Entgegenhaltungen:
EP-A- 0 725 509          US-A- 5 285 474
US-A- 5 694 422          US-A- 5 796 814

• MELSA P J W ET AL: "IMPULSE RESPONSE SHORTENING FOR DISCRETE MULTITONE TRANSCEIVERS" IEEE TRANSACTIONS ON COMMUNICATIONS,US,IEEE INC. NEW YORK, Bd. 44, Nr. 12, Seite 1662-1672 XP000640581 ISSN: 0090-6778
• BLADEL VAN M ET AL: "TIME-DOMAIN EQUALIZATION FOR MULTICARRIER COMMUNICATION" IEEE GLOBAL TELECOMMUNICATIONS CONFERENCE (GLOBECOM),US,NEW YORK, IEEE, Seite 167-171 XP000773405 ISBN: 0-7803-2510-9
• CHOW J S ET AL: "EQUALIZER TRAINING ALGORITHMS FOR MULTICARRIER MODULATION SYSTEMS" PROCEEDINGS OF THE INTERNATIONAL CONFERENCE ON COMMUNICATIONS (ICC),US,NEW YORK, IEEE, Bd. -, Seite 761-765 XP000371187 ISBN: 0-7803-0950-2

**Beschreibung**

Die Erfindung betrifft einen digitalen Empfänger für ein mit Diskreter Multiton-Modulation erzeugtes Signal nach dem Oberbegriff von Patentanspruch 1; wie aus der EP-A-0 725 509 bekannt.

Die US-A-5,694,422 offenbart einen festen Equalizer und einen entsprechendes Equalizer-Betriebsverfahren. Insbesondere offenbart diese Druckschrift einen digitalen Empfänger mit Zeitbereichsentzerrer, der als digitales Filter mit festen Koeffizienten ausgeführt ist und dem ein Analog-Digital-Umsetzer vorgeschalter ist. Das Filter kann als Tiefpassoder Hochpassfilter ausgelegt werden, und es kann ferner aus einer Vielzahl von digitalen Filtern bestehen.

Die diskrete Multiton-Modulation (DMT) - auch Mehrträgerniodulation - ist ein Modulationsverfahren, das sich insbesondere zur Übertragung von Daten über linear verzerrende Kanäle eignet. Gegenüber sogenannten Einträgerverfahren wie beispielsweise die Amplitudenmodulation, die nur eine Trägerfrequenz aufweist, werden bei der diskreten Multiton-Modulation eine Vielzahl von Trägerfrequenzen benutzt. Jede einzelne Trägerfrequenz wird in der Amplitude und Phase nach der Quadraturamplituden-Modulation (QAM) moduliert. Man erhält somit eine Vielzahl von QAM-modulierten Signalen. Pro Trägerfrequenz kann dabei eine bestimmte Anzahl an Bits übertragen werden. Die diskrete Multiton-Modulation wird für den digitalen Rundfunk DAB (Digital Audio Broadcast) unter der Bezeichnung OFDM (Orthogonal Frequency Division Multiplex) und zur Übertragung von Daten über Telefonleitungen unter der Bezeichnung ADSL (Asymmetric Digital Subscriber Line) eingesetzt.

Bei ADSL werden mit Hilfe eines DMT modulierten Signals Daten von einer Vermittlungsstelle an einen analog angeschlossenen Teilnehmer über die Teilnehmerleitung übertragen. Dabei ist durch ETSI- und ANSI-Standards festgelegt, daß jede Trägerfrequenz ungefähr 4 kHz Bandbreite aufweist und höchstens bis zu 15 Bit/s/Hz transportiert. Die tatsächliche Anzahl von Bits/s/Hz kann bei jeder Trägerfrequenz unterschiedlich sein, wodurch die Datenrate und das Sendespektrum an den Übertragungskanal anpaßbar ist.

Ein DMT-Übertragungssystem weist einen Kodierer auf, der die Bits eines seriellen digitalen Datensignals, das übertragen werden soll, zu Blöcken zusammenfaßt. Jeweils einer bestimmten Anzahl von Bits in einem Block wird eine komplexe Zahl zugeordnet. Durch eine komplexe Zahl wird eine Trägerfrequenz $f_i = i/T$ mit $i = 1, 2, ..., N/2$ der diskreten Multiton-Modulation dargestellt, wobei alle Trägerfrequenzen $f_i$ äquidistant verteilt sind. T ist die Zeitdauer eines Blocks. Durch eine inverse Fouriertransformation werden die durch die komplexen Zahlen dargestellten Trägerfrequenzen in den Zeitbereich transformiert und stellen dort unmittelbar N Abtastwerte eines zu sendenden DMT-Signals dar. Um die schnelle inverse Fouriertransformation (IFFT = Inverse Fast Fourier Transformation) anwenden zu können, wird für N eine Zweierpotenz gewählt. Dadurch wird der Aufwand für die inverse schnelle Fouriertransformation geringer.

Nach der inversen schnellen Fouriertransformation wird ein Cyclic-Prefix durchgeführt, wobei die letzten M (M < N) der Abtastwerte noch einmal an den Anfang eines Blockes gehängt werden. Dadurch wird einem Empfänger ein periodisches Signal vorgetäuscht, wenn der durch einen Übertragungskanal erzeugte Einschwingvorgang nach M Abtastwerten entsprechend einer Zeit $T \cdot M/N$ abgeklungen ist. Der Entzerrungsaufwand im Empfänger läßt sich durch das Cyclic-Prefix stark reduzieren, da nach der Demodulation im Empfänger nur mit der inversen Übertragungsfunktion des Übertragungskanals multipliziert werden muß, um die linearen Verzerrungen des Übertragungskanals zu beseitigen. Dies benötigt für jede Trägerfrequenz eine komplexe bzw. vier reelle Multiplikationen.

Bei ADSL ist der physische Übertragungskanal eine Zweidrahtleitung (Kupferdoppelader) des Telefonnetzes. Die Zweidrahtleitung benötigt im Verhältnis zur Länge eines Blocks eine große Zeit für den Einschwingvorgang. Andererseits soll die durch den Cyclic-Prefix benötigte zusätzliche Übertragungskapazität möglichst gering sein.

Bei einer Blocklänge von N = 512 ist bei ADSL ein Cyclic-Prefix von M = 32 festgelegt. Jedoch ist nach M = 32 Werten der Einschwingvorgang der Zweidrahtleitung noch nicht abgeklungen. Dadurch treten im Empfänger zusätzliche Fehler auf, die durch einen Frequenzbereichsentzerrer nicht beseitigt werden können.

Solche zusätzlichen Fehler können im Empfänger mit Hilfe besonderer Signalverarbeitungsmaßnahmen reduziert werden.

Dazu wird ein Zeitbereichsentzerrer (TDEQ = Time domain Equalizer) einem Demodulator vorgeschaltet. Der Zeitbereichsentzerrer ist als ein digitales Transversalfilter, dessen Koeffizienten einstellbar sind, ausgeführt. Die Aufgabe des Zeitbereichsentzerrers ist eine Verkürzung des Einschwingvorgangs des Übertragungskanals. Der Entwurf solcher Zeitbereichsentzerrer ist Al-Dhahir, N., Cioffi, J.M., "Optimum Finite-Length Equalization for Multicarrier Transceivers", IEEE Trans.on Comm., Vol.44, No.1, Jan.1996 zu entnehmen. Nachteilig ist jedoch die hohe Anzahl an Koeffizienten, die das als Zeitbereichsentzerrer eingesetzte digitale Transversalfilter aufweist, und die aufwendige Adaption des digitalen Transversalfilters. Bei einer Filterlänge von 20 bis 40 Koeffizienten sind pro Sekunde ungefähr 50 bis 100 Millionen Multiplikationen durchzuführen. Zusätzlich muß zur Adaption des digitalen Transversalfilters jeder Koeffizient eingestellt werden.

Das der Erfindung zugrundeliegende technische Problem liegt daher darin, einen digitalen Empfänger für ein mit Diskreter Multiton-Modulation erzeugtes Signal anzugeben, der einen Zeitbereichsentzerrer aufweist, der schneller adaptierbar ist und der weniger Multiplikationen pro Sekunde durchführt.

Dieses Problem wird durch einen digitalen Empfänger für ein mit Diskreter Multiton-Modulation erzeugtes Signal mit den Merkmalen von Patentanspruch 1 gelöst. Vorteilhafte Ausgestaltungen ergeben sich aus den jeweiligen abhängigen Ansprüchen.

Die Erfindung betrifft einen digitalen Empfänger für ein mit Diskreter Multiton-Modulation erzeugtes Signal. Der digitale Empfänger weist einen Analog-Digital-Umsetzer, dem das mit Diskreter Multiton-Modulation erzeugte Signal zugeführt wird, und einem dem Analog-Digital-Umsetzer nachgeschalteten Zeitbereichsentzerrer auf. Der Zeitbereichsentzerrer weist wiederum ein digitales Filter mit festen Koeffizienten auf. Von Vorteil sind dabei die festen Koeffizienten des digitalen Filters, die keinen Aufwand zur Anpassung erfordern, wie er bei adaptiven digitalen Filtern erforderlich ist.

Das digitale Filter weist erfindungsgemäß als feste Koeffizienten durch Schiebeoperationen darstellbare Werte auf. Vorteilhafterweise können dadurch Multiplikationen durch Schiebeoperationen ersetzt werden, die weniger aufwendig sind.

In einer besonders bevorzugten Ausführungsform. weist das digitale Filter als feste Koeffizienten ganzzahlige Werte auf. Besonders vorteilhaft ist dabei, daß Operationen mit ganzzahligen Werten weniger aufwendig als Operationen mit Gleitkommaoperationen sind.

In einer bevorzugten Ausführungsform weist das digitale Filter eine Nullstelle bei 0 Hz auf, wodurch sich vorteilhafterweise die Impulsantwort des Übertragungssystems verkürzt.

In einer weiteren bevorzugten Ausführungsform weist das digitale Filter eine Hochpaß-Übertragungsfunktion auf.

In einer besonders bevorzugten Ausführungsform weist das digitale Filter eine Serienschaltung einer Vielzahl von digitalen Filtern erster Ordnung auf. Vorteilhafterweise sind die Filter erster Ordnung sehr einfach realisierbar.

In einer weiteren besonders bevorzugten Ausführungsform weist jedes digitale Filter erster Ordnung einen Zustandsspeicher, ein Schieberegister, eine digitale Subtrahiererschaltung und eine digitale Addiererschaltung auf. Von Vorteil ist dabei der einfache Aufbau jedes Filters erster Ordnung, wobei keine aufwendigen Multipliziererstufen benötigt werden.

Weitere Vorteile, Merkmale und Anwendungsmöglichkeiten der Erfindung ergeben sich aus der nachfolgenden Beschreibung von Ausführungsbeispielen in Verbindung mit der Zeichnung. In der Zeichnung zeigt

Fig.1     eine Übertragungsstrecke mit einem digitalen Empfänger für ein mit Diskreter Multiton-Modulation erzeugtes Signal; und

Fig.2     ein Ausführungsbeispiel eines Zeitbereichsentzerrers nach der Erfindung; und

Fig.3     ein Diagram, das die Wirkung eines Zeitbereichsentzerrers nach der Erfindung darstellt.

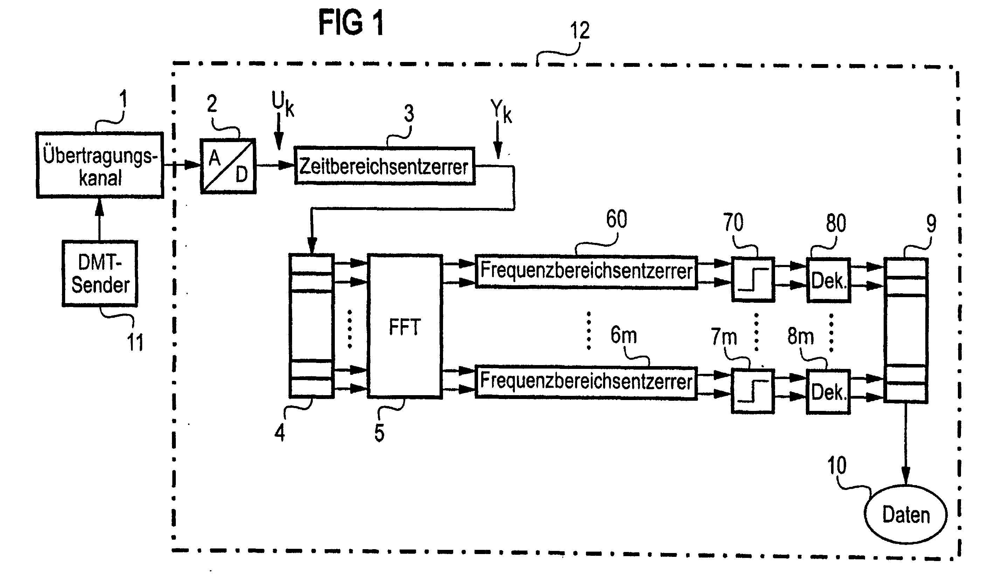

Bei der in Figur 1 dargestellten Übertragungsstrecke mit einem digitalen Empfänger 12 erzeugt ein DMT-Sender 11 ein mit Diskreter Multiton-Modulation moduliertes Signal. Das Signal weist dabei N/2 Trägerfrequenzen $f_i$ auf, die durch die diskrete Multiton-Modulation erzeugt wurden. Jede Trägerfrequenz ist dabei in der Amplitude und Phase mit der Quadraturamplituden-Modulation moduliert. Das Signal wird im DMT-Sender 11 mit einem Cyclic-Prefix von M Abtastwerten versehen und durch eine Digital-Analog-Umsetzung in ein analoges Signal für die Übertragung umgesetzt. Der DMT-Sender 11 überträgt das Signal über einen Übertragungskanal 1 an den digitalen Empfänger 12.

Der Übertragungskanal 1 ist ein linear verzerrender Kanal. Bei ADSL-Übertragungsstrecken ist der Übertragungskanal eine Zweidrahtleitung. Solche durch den Übertragungskanal 1 erzeugten linearen Verzerrungen werden im digitalen Empfänger 12 durch Entzerrer, die im Frequenzbereich arbeiten, wieder beseitigt.

Im digitalen Empfänger 12 wird das Signal einem Analog-Digital-Umsetzer 2 zugeführt, der es in eine Folge von digitalen Werten $u_k$ umsetzt.

Diese Folge von digitalen Werten $u_k$ wird einem Zeitbereichsentzerrer 3 zugeführt. Der Zeitbereichsentzerrer 3 dient zur Verkürzung der Einschwingzeit des DMT-Senders 11, des Übertragungskanals 1 und des Zeitbereichsentzerrers 3 selbst. Bei einer Einschwingzeit, die die Cyclic-Prefix-Zeitdauer übersteigt, entstehen in den Entscheiderschaltungen 70 bis 7n des digitalen Empfängers 12 Fehler. Der Zeitbereichsentzerrer 3 soll die Einschwingzeit verkürzen, ohne Nullstellen im Frequenzbereich, der für die Übertragung genutzt wird, zu erzeugen. Dazu weist der Zeitbereichsentzerrer 3 ein digitales Filter mit festen Koeffizienten auf, das die folgende Übertragungsfunktion besitzt ($z = u_k$) :

$$H(z) = \prod_{v=1}^{n} \left( \frac{1 - z^{-1}}{1 - c_v \cdot z^{-1}} \right) \qquad \text{mit} \quad c_v = \pm(1 - 2^{-L_v}) \qquad (1)$$

Dies ist die Übertragungsfunktion eines mehrstufigen digitalen Filters, das feste Koeffizienten $c_v$ aufweist und durch eine Serienschaltung von n zweiten digitalen Filtern erster Ordnung mit einer Übertragungsfunktion

$$H_v(z) = \frac{1-z^{-1}}{1-C_v \cdot z^{-1}} \text{ mit } c_v = \pm(1-2^{-L_v}) \tag{2}$$

erzeugt wird. Die Übertragungsfunktion H(z) des Zeitbereichsentzerrers 3 weist einen Nullstelle bei 0 Hz auf und ist damit die Übertragungsfunktion eines Hochpaßfilters. Dadurch wird der Einschwingvorgang des Übertragungskanals am wirkungsvollsten verkürzt.

Die vom Zeitbereichsentzerrer 3 erzeugten digitalen Werte werden einem Seriell-/Parallel-Wandler 4 zugeführt, der das Cyclic-Prefix entfernt und Blöcke erzeugt, die einem schnellen diskreten Fouriertransformator 5 zugeführt werden.

Der schnelle diskrete Fouriertransformator 5 setzt die durch die Blöcke dargestellten Signale vom Zeit- in den Frequenzbereich um. Jeder umgesetzte Block am Ausgang des schnellen diskreten Fouriertransformators 5 weist N/2 komplexe Zahlen auf. Durch jede komplexe Zahl wird eine Trägerfrequenz $f_i = i/T$ mit $i = 1, 2, ..., N/2$ der diskreten Multiton-Modulation dargestellt, wobei alle Trägerfrequenzen $f_i$ äquidistant verteilt sind. T ist die Zeitdauer eines Blocks.

Dem schnellen diskreten Fouriertransformator 5 sind je Trägerfrequenz $f_1, ..., f_{N/2}$ ein Frequenzbereichsentzerrer 60, ..., 6m nachgeschaltet, der eine Entzerrung im Frequenzbereich durchführt. Dazu wird jede komplexe Zahl des umgesetzten Blocks, die eine Trägerfrequenz darstellt, mit der inversen Übertragungsfunktion des Übertragungskanals 1 multipliziert. Dies erfordert eine komplexe Multiplikation bzw. vier reelle Multiplikationen.

Jedem Frequenzbereichsentzerrer 60, ..., 6m ist jeweils eine Entscheidungsschaltung 70, ..., 7m nachgeschaltet, die aus dem Ausgangssignal des Frequenzbereichsentzerrers 60, ..., 6m einen mehrstufigen Wert erzeugt.

Jeder Entscheidungsschaltung 70, ..., 7m ist jeweils eine Dekodiererschaltung 80, ..., 8m nachgeschaltet, die aus dem mehrstufigen Wert einen digitalen Wert erzeugt.

Die Ausgangssignale der Dekodiererschaltungen 80, ..., 8m werden parallel einem Parallel-/Seriell-Wandler 9 zugeführt, der mit einer Datensenke 10 verbunden ist. Der Parallel/Seriell-Wandler 9 führt der Datensenke 10 eine seriellen Strom von digitalen Daten zu, die den digitalen Daten des DMT-Senders 11 entsprechen.

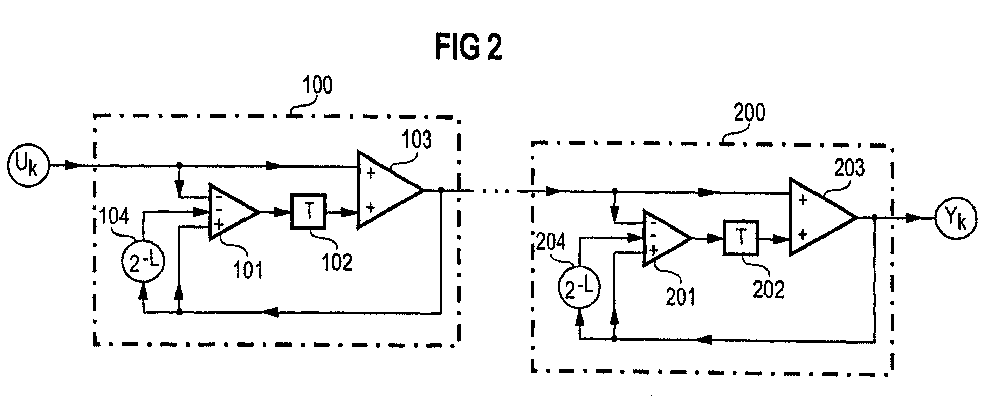

In Figur 2 ist ein Ausführungsbeispiel eines Zeitbereichsentzerrers nach der Erfindung dargestellt.

Der Zeitbereichsentzerrer weist eine Serienschaltung von n zweiten digitalen Filtern erster Ordnung mit einer Übertragungsfunktion gemäß Gleichung (2) auf. In Figur 2 sind lediglich zwei zweite digitale Filter erster Ordnung 100 und 200 dargestellt. Weitere zweite digitale Filter erster Ordnung sind durch Punkte angedeutet.

Alle zweiten digitale Filter erster Ordnung 100 und 200 sind gleich aufgebaut. Eine diskrete Eingangswertefolge wird einem ersten invertierenden Eingang einer digitalen Subtrahiererschaltung 101 bzw. 201 und parallel einem ersten nichtinvertierenden Eingang einer digitalen Addiererschaltung 103 bzw. 203 zugeführt. Ein Ausgang der digitalen Addiererschaltung 103 bzw. 203 ist ein Ausgang des zweiten digitalen Filters erster Ordnung und wird parallel auf einen nichtinvertierenden Eingang der digitalen Subtrahiererschaltung und über ein Schieberegister auf einen zweiten invertierenden Eingang der digitalen Subtrahiererschaltung 101 bzw. 201 rückgekoppelt. Das Schieberegister 104 bzw. 204 multipliziert einen diskreten Ausgangswert mit durch bitweises Rechtsschieben. Dadurch wird der diskrete Ausgangswert mit einer ganzzahligen Zahl $2^{-L}$ multipliziert. Ein Ausgang der digitalen Subtrahiererschaltung 101 bzw. 201 wird über einen Zustandsspeicher 102 bzw. 202 auf einen zweiten nichtinvertierenden Eingang der digitalen Addiererschaltung 103 bzw. 203 geführt. Der Zustandsspeicher 102 bzw. 202 bewirkt eine Verzögerung um eine Taktperiode des Taktes, mit der die diskrete Eingangsfolge getaktet ist.

Wird für L = 0 gewählt, sind die zweiten digitalen Filter 100 und 200 nichtrekursiv. In diesem Fall werden die Koeffizienten cv gemäß Gleichung (2) zu Null.

In einem nicht dargestellten Ausführungsbeispiel unterscheiden sich die zweiten digitalen Filter in der ganzzahligen Zahl $2^{-L_v}$, mit der ein diskreter Ausgangswert eines zweiten digitalen Filters im Rückkoppelpfad multipliziert wird. In diesem Ausführungsbeispiel sind die Koeffizienten $c_v$ gemäß Gleichung (1) für jedes zweite digitale Filter unterschiedlich und das digitale Filter, das sich aus der Serienschaltung der zweiten digitalen Filter ergibt, weist eine Übertragungsfunktion gemäß Gleichung (1) auf.

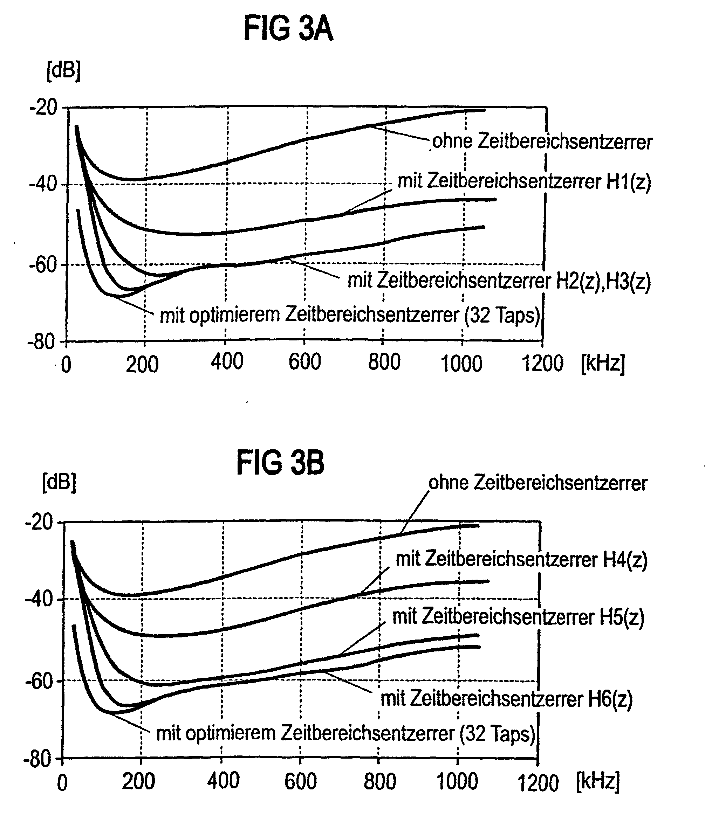

Figur 3 stellt in zwei Diagrammen die Wirkung von sechs verschiedenen Ausführungsbeispielen von Zeitbereichsentzerrern nach der Erfindung dar. Dazu wurde in einem ADSL-Übertragungssystem mit einer Zweidrahtleitung von 3 km Länge und einem Durchmesser von 0,4 mm der Kupferdrähte der Signal/Störabstand am Eingang einer Entscheiderschaltung simuliert.

Es wurden ausschließlich Einflüsse des Zeitbereichsentzerrers betrachtet. Der Signal-/Störabstand ist über den gesamten für eine ADSL-Übertragung genutzten Frequenzbereich aufgetragen. Dabei ist für jeden der sechs verschiedenen Zeitbereichsentzerrer mit Übertragungsfunktionen $H_1(z)$ bis $H_6(z)$ ein Kurvenverlauf angegeben. Die Übertragungsfunktionen $H_1(z)$ bis $H_6(z)$ lauten:

$$H_1(z) = 1 - z^{-1}$$

$$H_2(z) = (1 - z^{-1})^2$$

$$H_3(z) = (1 - z^{-1})^3$$

$$(3)$$

$$H_4(z) = \left( \frac{1 - z^{-1}}{1 - 0{,}5 \cdot z^{-1}} \right)$$

$$H_5(z) = \left( \frac{1 - z^{-1}}{1 - 0{,}5 \cdot z^{-1}} \right)^2$$

$$H_6(z) = \left( \frac{1 - z^{-1}}{1 - 0{,}5 \cdot z^{-1}} \right)^3$$

Zum Vergleich ist ein Kurvenverlauf ohne Zeitbereichsentzerrer und ein Kurvenverlauf mit einem optimierten Zeitbereichsentzerrer mit 32 Koeffizienten (32 Taps) angegeben. Deutlich sichtbar ist in beiden Diagrammen die Verbesserung des Signal-/Störabstand im Bereich der unteren Frequenzen. Bei Zeitbereichsentzerrern mit einem digitalen Filter der zweiten, dritten oder einer höheren Ordnung unterscheidet sich der Signal-/Störabstand von dem optimierten Zeitbereichsentzerrer mit 32 Koeffizienten ab einer Frequenz von ca. 300 kHz nur um wenige Dezibel.

**Patentansprüche**

1. Digitaler Empfänger für ein mit Diskreter Multiton-Modulation erzeugtes Signal (12), der einen Analog-Digital-Umsetzer (2), dem das mit Diskreter Multiton-Modulation erzeugte Signal zugeführt wird, und einen dem Analog-Digital-Umsetzer nachgeschalteten Zeitbereichsentzerrer (3) aufweist, wobei der Zeitbereichsentzerrer (3) ein digitales Filter mit festen Koeffizienten (104, 204) aufweist,
**dadurch gekennzeichnet, dass**
das digitale Filter (100, 200) als die festen Koeffizienten (104, 204) durch Schiebeoperationen darstellbare Werte aufweist.

2. Digitaler Empfänger nach Anspruch 1
**dadurch gekennzeichnet, daß**
das digitale Filter (100, 200) als feste Koeffizienten (104, 204) ganzzahlige Werte aufweist.

3. Digitaler Empfänger nach einem der vorhergehenden Ansprüche,
**dadurch gekennzeichnet, daß**
das digitale Filter (100, 200) eine Nullstelle bei 0 Hz aufweist.

4. Digitaler Empfänger nach einem der vorhergehenden Ansprüche,
**dadurch gekennzeichnet, daß**
das digitale Filter (100, 200) eine Hochpaß-Übertragungsfunktion aufweist.

5. Digitaler Empfänger nach einem der vorhergehenden Ansprüche,
**dadurch gekennzeichnet, daß**

das digitale Filter eine Serienschaltung einer Vielzahl von digitalen Filtern erster Ordnung (100, 200) aufweist.

6. Digitaler Empfänger nach Anspruch 5,
   **dadurch gekennzeichnet, daß**
   jedes digitale Filter erster Ordnung einen Zustandsspeicher (102, 202), ein Schieberegister (104, 204), eine digitale Subtrahiererschaltung (101, 201) und eine digitale Addiererschaltung (103, 203) ausweist.

**Claims**

1. Digital receiver for a signal (12) produced using discrete multitone modulation, which receiver has an analogue/digital converter (2) to which the signal produced using discrete multitone modulation is supplied, and has a time-domain equalizer (3) connected downstream from the analogue/digital converter, the time-domain equalizer (3) having a digital filter with fixed coefficients (104, 204),
   **characterized in that**
   the digital filter (100, 200) has values which can be represented as the fixed coefficients (104, 204) by means of shift operations.

2. Digital receiver according to Claim 1,
   **characterized in that**
   the digital filter (100, 200) has integer values as fixed coefficients (104, 204).

3. Digital receiver according to one of the preceding claims,
   **characterized in that**
   the digital filter (100, 200) has a zero at 0 Hz.

4. Digital receiver according to one of the preceding claims,
   **characterized in that**
   the digital filter (100, 200) has a high-pass transfer function.

5. Digital receiver according to one of the preceding claims,
   **characterized in that**
   the digital filter has a series of circuits comprising a large number of first-order digital filters (100, 200).

6. Digital receiver according to Claim 6,
   **characterized in that**
   each first-order digital filter has a state memory (102, 202), a shift register (104, 204), a digital subtraction circuit (101, 201) and a digital addition circuit (103, 203).

**Revendications**

1. Récepteur numérique pour un signal (12) produit au moyen d'une modulation discrète à tonalités multiples, qui comporte un convertisseur analogique/numérique (2), auquel est envoyé le signal produit par la modulation discrète à tonalités multiples, et un correcteur (3) de distorsions dans le domaine temporel, qui est branché en aval du convertisseur analogique/numérique, le correcteur (3) de distorsions dans le domaine temporel comportant un filtre numérique ayant des coeffcients fixes (104, 204),
   **caractérisé en ce que** le filtre numérique (100, 200) comporte, en tant que coefficient fixe (104, 204), des valeurs pouvant être représentées par des opérations de décalage.

2. Récepteur numérique selon la revendication 1, **caractérisé en ce que** le filtre numérique (100, 200) comporte, comme coefficients fixes (104, 204), des valeurs formées de nombres entiers.

3. Récepteur numérique selon l'une des revendications précédentes, **caractérisé en ce que** le filtre numérique (100, 200) possède un point de zéro à 0 Hz.

4. Récepteur numérique selon l'une des revendications précédentes, **caractérisé en ce que** le filtre numérique (100, 200) possède une fonction de transfert de filtre passe-haut.

**5.** Récepteur numérique selon l'une des revendications précédentes, **caractérisé en ce que** le filtre numérique possède un circuit série formé d'une multiplicité de filtres numériques du premier ordre (100, 200).

**6.** Récepteur numérique selon la revendication 5, **caractérisé en ce que** chaque filtre numérique du premier ordre possède une mémoire d'état (102, 202), un registre à décalage (104, 204), un circuit soustracteur numérique (101, 201) et un circuit additionneur numérique (103, 203).

# FIG 1

FIG 2

## FIG 3A

[dB]

-20

-40

-60

-80

0    200    400    600    800    1000    1200    [kHz]

ohne Zeitbereichsentzerrer

mit Zeitbereichsentzerrer H1(z)

mit Zeitbereichsentzerrer H2(z),H3(z)

mit optimierem Zeitbereichsentzerrer (32 Taps)

## FIG 3B

[dB]

-20

-40

-60

-80

0    200    400    600    800    1000    1200    [kHz]

ohne Zeitbereichsentzerrer

mit Zeitbereichsentzerrer H4(z)

mit Zeitbereichsentzerrer H5(z)

mit Zeitbereichsentzerrer H6(z)

mit optimierem Zeitbereichsentzerrer (32 Taps)